# FASCICULE DE BREVET EUROPEEN

(11) **EP 3 172 837 B1**
(45) Date de publication et mention de la délivrance du brevet: **13.05.2020**
(21) Numéro de dépôt: 15741212.3
(22) Date de dépôt: 23.07.2015
(51) Int. Cl.: H03F 1/08, H03F 3/181

(54) **CONVERTISSEUR COURANT-TENSION, ÉTAGE D'ENTRÉE D'UN AMPLIFICATEUR ET AMPLIFICATEUR CORRESPONDANT**
STROM-SPANNUNGSWANDLER, VERSTÄRKEREINGANGSSTUFE UND ENTSPRECHENDER VERSTÄRKER
CURRENT-TO-VOLTAGE CONVERTER, AMPLIFIER INPUT STAGE AND CORRESPONDING AMPLIFIER

(30) Priorité: 23.07.2014 FR 1457115
(43) Date de publication de la demande: 31.05.2017
(73) Titulaire: Devialet, 75001 Paris (FR)
(72) Inventeur: HUFFENUS, Alexandre, F-38000 Grenoble (FR); CALMEL, Pierre-Emmanuel, F-78150 Le Chesnay (FR); GRAS, David Aimé Pierre, F-38130 Echirolles (FR)
(74) Mandataire: Lavoix
(86) Numéro de dépôt international: PCT/EP2015/066943
(87) Numéro de publication internationale: WO 2016/012569

(56) Documents cités:
- US-A1- 2005 035 797
- US-A1- 2008 136 492
- US-B1- 7 132 865

## Description

La présente invention concerne un convertisseur courant-tension selon la revendication 1.

Un tel convertisseur courant-tension trouve son application en particulier dans un amplificateur haute fidélité à haute linéarité.

Il est courant, dans un tel amplificateur, d'utiliser en entrée, un convertisseur numérique-analogique tel que le composant PCM 1792 de la société Texas Instruments. Ce convertisseur numérique-analogique possède une sortie en courant, de sorte que le signal analogique est modulé en intensité.

Dans la mesure où l'étage d'amplification placé en aval utilise en entrée une tension modulée, il convient de disposer un convertisseur courant-tension entre le convertisseur numérique-analogique et l'étage d'amplification proprement dit.

Les convertisseurs numérique-analogique à sortie en courant sont particulièrement appréciés pour le très faible niveau de distorsion harmonique qu'ils peuvent atteindre. La difficulté consiste à exploiter les qualités de tels convertisseurs numérique-analogique via un étage de conversion courant-tension qui n'impacte pas lui-même les performances du convertisseur numérique-analogique.

Les sources de courant contenues dans un tel convertisseur numérique-analogique sont connectées à une ou plusieurs sorties reliées à une masse virtuelle ou encore connectées entre une masse et une ou plusieurs sorties reliées à une masse virtuelle. De telles connexions sont traditionnellement réalisées au moyen d'un montage à amplificateur opérationnel.

Une masse virtuelle est un potentiel fixe.

De cette manière, tous les transistors du convertisseur numérique-analogique fonctionnent à courant et tension constants, donc de façon optimale, quelque soit la modulation du signal de sortie.

Afin de préserver cette absence de distorsion, les convertisseurs courant-tension placés en aval peuvent également, dans une implémentation différente de celle du montage à amplificateur opérationnel, comporter des étages spécifiques, dits « à grille commune » à base de transistors MOSFET (de l'anglais *Métal Oxide Semiconductor Field Effect Transistor)* ou dits « à base commune » à base de transistors bipolaires. De tels étages à grille ou base commune fonctionnent en boucle ouverte.

Ce type de montage comprenant des transistors à base ou grille commune, plus communément appelé « cascode », est décrit dans le document WO 2011/107671. Le document US2005035797 A1 décrit le circuit d'un filtre de boucle d'une boucle à verrouillage de phase, ayant des moyens de compensation de courant de fuite.

Cependant, les transistors de tels étages à base ou grille commune induisent des courants d'erreur venant se superposer au courant issu du convertisseur numérique-analogique, ce qui est à l'origine d'une dégradation du signal numérique de départ.

Les courants d'erreur sont notamment dus aux courants absorbés dans les grilles des transistors des étages à base ou grille commune.

Pour pallier ce problème, le document WO 2011/107671 décrit un convertisseur courant-tension disposant de moyens de réinjection du courant absorbé dans les grilles des transistors des étages à base ou grille commune.

Toutefois, un tel convertisseur courant-tension est inapte, lorsqu'il est réalisé sous forme d'un circuit intégré et non par des composants discrets, à compenser le courant absorbé dans le substrat sur lequel est formé le convertisseur courant-tension.

Le courant absorbé dans le substrat est en effet, particulièrement difficile à mesurer du fait qu'aucun potentiel de référence n'est défini au niveau de ce substrat.

De plus, lorsque le convertisseur courant-tension est réalisé sous forme de circuit intégré, il comprend des protections ESD, acronyme de « Electrostatic Discharge », aptes à protéger les composants du circuit intégré d'éventuelles décharges électrostatiques.

Toutefois, de telles protections ESD sont également à l'origine d'une absorption du courant issu du convertisseur numérique-analogique venant se superposer aux pertes précédentes.

Un but de l'invention est de proposer une solution pour maîtriser les pertes de courant dans le substrat d'un convertisseur courant-tension.

A cet effet, l'invention a pour objet un convertisseur courant-tension du type précité selon la revendication 1, comportant :
- un circuit jumeau comportant des composants identiques et disposés de manière similaire à ceux du circuit de traitement, le circuit jumeau comportant :
   + une source de tension,
   + une branche jumelle,
- un suiveur en tension connecté en entrée à la branche principale du circuit de traitement et en sortie à la branche jumelle du circuit jumeau, et
- des moyens de réinjection du courant en sortie du suiveur dans la branche principale du circuit de traitement.

Suivant des modes particuliers de réalisation, le convertisseur courant-tension comporte l'une ou plusieurs des caractéristiques suivantes :
- les moyens de réinjection comportent des moyens de mesure du courant en sortie du suiveur en tension, lesdits moyens de mesure du courant comprenant un circuit miroir de courant ;
- le circuit miroir de courant comporte un premier transistor assurant l'acheminement d'un courant vers le circuit jumeau et un deuxième transistor assurant la réinjection d'un courant dans la branche principale du circuit de traitement ;
- la sortie des moyens de réinjection du courant en sortie du suiveur est reliée à un nœud de la branche principale du circuit de traitement dont le potentiel est fixe ;
- le transistor du circuit de traitement comporte une protection ESD, le circuit jumeau comportant une protection ESD équivalente à la protection ESD du transistor ;
- le suiveur en tension comporte un amplificateur opérationnel à transconductance ;
- le suiveur en tension comporte une première sortie pour acheminer un courant au circuit jumeau et une deuxième sortie pour réinjecter un courant, égal au courant issu de la première sortie, dans la branche principale du circuit de traitement ;
- le suiveur en tension comporte un unique transistor ;
- le suiveur en tension est formé d'un premier transistor et d'un deuxième transistor de polarité inverse à celle du premier transistor, le deuxième transistor étant apte à compenser les chutes de tension entre la source et la grille du premier transistor ;
- chaque transistor forme un étage cascode, imposant une tension fixe aux bornes des sources de courant auxquels ils sont reliés ;
- le convertisseur courant-tension est réalisé sur un circuit intégré ;
- les transistors du circuit de traitement et du circuit jumeau sont réalisés sur un même substrat semi-conducteur.

L'invention a également pour objet un étage d'entrée d'un amplificateur haute fidélité à haute linéarité et faible taux de distorsion comportant un convertisseur numérique-analogique à sortie en courant et un convertisseur courant-tension du type précité.

L'invention a également pour objet un amplificateur haute fidélité à haute linéarité et faible taux de distorsion comportant un étage d'entrée du type précité, et un étage d'amplification, connecté en série à l'étage d'entrée.

L'invention sera mieux comprise à la lecture de la description qui va suivre, donnée uniquement à titre d'exemple et faite en se référant aux dessins sur lesquels :
- la figure 1 est une vue schématique d'un amplificateur haute fidélité selon l'invention ;
- la figure 2 est un schéma électrique d'un étage d'entrée de l'amplificateur de la figure 1 suivant un premier mode de réalisation ;
- la figure 3 est un schéma électrique d'un étage d'entrée de l'amplificateur de la figure 1 suivant un deuxième mode de réalisation; et
- la figure 4 est un schéma électrique d'un étage d'entrée de l'amplificateur de la figure 1 suivant un troisième mode de réalisation.

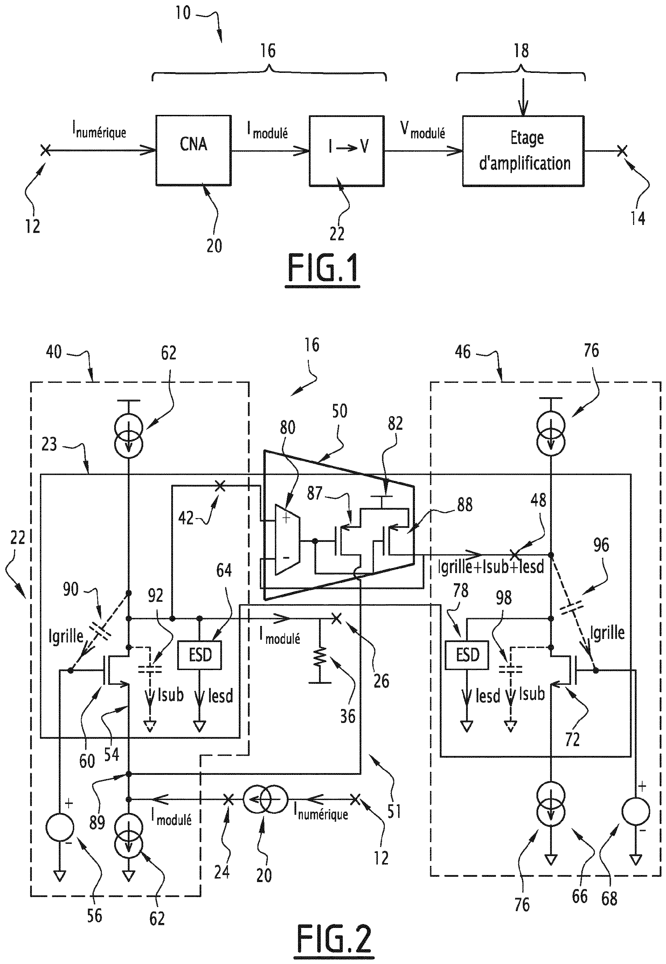

L'amplificateur 10, représenté schématiquement sur la figure 1, est un amplificateur haute fidélité propre à recevoir sur une entrée 12 un signal numérique et à produire en sortie 14 un signal analogique amplifié.

Comme connu en soi, l'amplificateur 10 comporte un étage d'entrée 16 assurant la conversion du signal numérique d'entrée en un signal analogique de sortie modulé en tension, ainsi qu'un étage d'amplification 18, assurant la fourniture d'une puissance suffisante pour la charge placée en aval, à savoir un ou plusieurs hauts parleurs. Il s'agit de préférence d'un étage d'amplification de classe A.

L'étage d'entrée 16 comporte un convertisseur numérique-analogique 20 dont l'entrée est reliée à l'entrée 12 de l'amplificateur pour recevoir un signal numérique I_{numérique}. Ce convertisseur numérique-analogique est propre à fournir en sortie un signal analogique modulé en courant I_{modulé}. Le convertisseur numérique-analogique est, par exemple, un PCM 1792 de la société Texas Instruments.

Le courant I_{modulé} comporte une composante variable et peut comporter une composante fixe.

La sortie du convertisseur numérique-analogique 20 est reliée à un convertisseur courant-tension 22 selon l'invention.

Ce convertisseur courant-tension 22 est propre à fournir une tension modulée V_{modulé} avec un gain en tension, à partir du courant modulé I_{modulé} produit par le convertisseur numérique-analogique 20.

La sortie du convertisseur courant-tension 22 est reliée à l'entrée de l'étage d'amplification 18, comme connu en soi.

Sur la figure 2 est illustré une partie de l'étage d'entrée 16 correspondant à un premier mode de réalisation du convertisseur courant-tension 22.

Sur cette figure 2, le convertisseur numérique-analogique 20 est schématisé par une source de courant.

Le convertisseur courant-tension 22 est réalisé sur un circuit intégré, par exemple, du type ASIC (acronyme de l'anglais *Application-Specific Integrated Circuit)* comprenant un substrat semi-conducteur 23. Ce substrat 23 est, par exemple, un substrat semi-conducteur à base de silicium.

Le convertisseur courant-tension 22 présente une entrée 24 reliée à la sortie du convertisseur numérique-analogique 20 et une sortie en tension 26 propre à être reliée directement à l'étage d'amplification 18.

Le convertisseur courant-tension 22 comporte une résistance de conversion 36 dont une borne est reliée à la sortie 26, et dont l'autre borne est reliée à un potentiel de référence.

La résistance 36 est propre à convertir le courant I_{modulé} en sortie du convertisseur numérique-analogique 20 en une tension V_{modulée}.

Le convertisseur courant-tension 22 comporte, en outre, un circuit de traitement 40 propre à acheminer le courant I_{modulé} depuis l'entrée 24 vers la résistance 36. Un tel circuit de traitement 40 comporte un nœud 42 dont le potentiel est identique au potentiel de la sortie 26.

Le convertisseur courant-tension 22 comporte également un circuit jumeau 46 comportant un nœud 48 avec exactement les mêmes composants non-linéaires connectés sur ce nœud 48 que les composants non-linéaires du circuit de traitement 40 connectés sur le nœud 42 du circuit de traitement 40.

Un composant non-linéaire est un composant, tel qu'un dipôle électrique, disposant d'une tension électrique et étant traversé par un courant électrique de sorte que la tension et le courant de ce composant ne soient pas liés par une équation différentielle linéaire à coefficients constants.

Le convertisseur courant-tension 22 comporte, en outre, un suiveur en tension 50 imposant un potentiel au nœud 42 du circuit de traitement 40 identique au potentiel du nœud 48 du circuit jumeau 46. Le nœud 42 est, en effet, relié à une entrée du suiveur 50 et le nœud 48 est relié à une sortie du suiveur 50. Ainsi, le circuit de traitement 40 et le circuit jumeau 46 sont reliés l'un à l'autre au moyen du suiveur 50.

Le suiveur en tension 50 est réalisé sur le substrat semi-conducteur 23.

Le suiveur en tension 50 comporte, dans ce premier mode de réalisation, un amplificateur opérationnel à transconductance. Un tel amplificateur opérationnel à transconductance est propre à fournir un courant de sortie proportionnel à la tension appliquée en entrée.

Le convertisseur courant-tension 22 comporte également des moyens de réinjection 51 aptes à réinjecter le courant en sortie du suiveur en tension 50 dans le circuit de traitement 40.

Le circuit de traitement 40 est apte à annuler la composante continue du courant I_{modulé} en provenance du convertisseur numérique-analogique 20 lorsque le courant d'entrée comporte une composante continue.

Le circuit de traitement 40 comprend une branche principale 54 et une source de tension 56, la source de tension 56 étant reliée par l'une de ses extrémités à un potentiel fixe.

La branche principale 54 comporte un transistor 60 réalisé sur le substrat semi-conducteur 23 du convertisseur courant-tension 22. La grille de ce transistor 60 est reliée à la source de tension 56.

L'entrée 24 est reliée à la sortie 26 au travers de la source et du drain du transistor 60 du circuit de traitement 40.

Le transistor 60 est, par exemple, un transistor MOSFET.

La branche principale 54 comporte, en outre, au moins une source de courant 62 en série avec le transistor 60 et un potentiel de référence.

Dans le premier mode de réalisation illustré sur la figure 2, la branche principale 54 comporte deux sources de courant 62, l'une étant reliée au drain du transistor 60 du circuit de traitement 40 et l'autre à la source de ce transistor 60.

Le transistor 60 forme un premier étage cascode ou à grille ou base commune de l'étage d'entrée 16.

Un tel étage cascode impose un potentiel constant à l'entrée 24, quelle que soit la tension au niveau de la sortie 26.

De plus, un tel étage cascode permet de garantir que les sources de courant 62 ne présentent pas de variation de tension à leurs bornes lorsque la tension au niveau de la sortie 26 varie, et ce même lorsque cette tension varie de plusieurs dizaines de Volt.

Le circuit de traitement 40 comporte également d'autres étages cascode donc d'autres transistors 60, non visible sur la figure 2, ainsi que des sources de courant et de tension qui leur sont associés.

Le circuit de traitement 40 est, en outre, muni d'une protection ESD 64 disposée entre le substrat 23 et la sortie 26. La protection ESD 64 est, par exemple, formée de diodes reliées à des potentiels de référence.

Sur la figure 2, seuls le transistor 60 et la protection ESD 64 du circuit de traitement 40 sont représentés réalisés sur le substrat 23. Cependant, il est tout à fait envisageable d'intégrer d'autres éléments du circuit de traitement 40 sur le substrat 23, tels que les sources de courant 62 et la source de tension 56.

Le circuit jumeau 46 comprend des composants non-linéaires identiques à ceux du circuit de traitement 40 de telle sorte que les composants non linéaires du circuit jumeau 46 soient disposés sur le même substrat 23 que les composants non-linéaires du circuit de traitement 40.

En particulier, le circuit jumeau 46 comporte des transistors identiques aux transistors 60 du circuit de traitement 40 et disposés sur le même substrat 23. De même, le circuit jumeau 46 comporte une protection ESD identique à la protection ESD 64 du circuit de traitement 40 et disposée sur le même substrat 23.

Le circuit jumeau 46 comporte ainsi une branche jumelle 66 identique à la branche principale 54 du circuit de traitement 40 et une source de tension 68 identique à la source de tension 56. En outre, la source de tension 68 est reliée par l'une de ses extrémités à un potentiel fixe.

La branche jumelle 66 comporte un transistor 72 réalisé sur le même substrat semi-conducteur 23 que le transistor 60 de la branche principale 54 du circuit de traitement 40. La grille de ce transistor 72 est reliée à la source de tension 68.

La branche jumelle 66 comporte, en outre, deux sources de courant 76 en série avec le transistor 72 entre deux potentiels de référence.

Le circuit jumeau 46 est, en outre, muni d'une protection ESD 78 identique à celle du transistor 60 et réalisée sur le même substrat semi-conducteur 23 que la protection ESD 64 du circuit de traitement 40.

Sur la figure 2, seuls le transistor 72 et la protection ESD 78 du circuit jumeau 46 sont représentés réalisés sur le substrat 23. Cependant, il est tout à fait envisageable d'intégrer d'autres éléments du circuit jumeau 46 sur le substrat 23, tels que les sources de courant 76 et la source de tension 68.

Le suiveur en tension 50 comprend, comme visible sur la figure 2, deux entrées en tension et deux sorties en courant. Comme indiqué précédemment, le suiveur en tension 50 de la figure 2 est un amplificateur opérationnel à transconductance.

Le suiveur en tension 50 comprend un premier étage 80 assurant la fonction d'étage d'entrée différentiel. Ce premier étage 80 est dans ce premier mode de réalisation un étage à transconductance. Pour un système recevant une tension d'entrée et fournissant un courant de sortie, il est entendu par « transconductance » le rapport entre la variation du courant de sortie et la variation de la tension d'entrée.

Le suiveur en tension 50 comporte, en outre, un deuxième étage 82 assurant, d'une part, l'acheminement du courant depuis une première sortie du suiveur 50 vers le nœud 48 du circuit jumeau 46 et constituant, d'autre part, les moyens de réinjection 51 depuis une deuxième sortie du suiveur 50.

Le premier étage 80 du suiveur en tension 50 comporte deux entrées en tension, l'une positive et l'autre négative. L'entrée positive du premier étage 80 est reliée au nœud 42 du circuit de traitement 40 et l'entrée négative du premier étage 80 est reliée au nœud 48 du circuit jumeau 46. L'entrée négative du premier étage 80 forme donc une boucle de contre réaction asservissant la tension en sortie du suiveur 50 sur la valeur de la tension en entrée du suiveur 50.

Le premier étage 80 du suiveur en tension 50 comporte une sortie reliée au deuxième étage 82 du suiveur en tension 50.

Le deuxième composant 82 du suiveur en tension 50 comprend deux transistors identiques 87, 88 reliés dans le suiveur en tension 50 au niveau de leur grille à la sortie du premier composant 80 et reliés entre eux au niveau de leur source.

Le premier transistor 87 est configuré pour réinjecter un courant identique à celui qui traverse le deuxième transistor 88, vers un nœud de la branche principale 54 du circuit de traitement 40, par exemple le nœud 89. Le drain du premier transistor 87 est, ainsi, connecté au nœud 89 ou à tout autre nœud de la branche principale 40.

Le potentiel du nœud de réinjection, tel que le nœud 89, est fixe.

Le deuxième transistor 88, identique au premier transistor 87, est configuré pour acheminer le courant de sortie de l'amplificateur opérationnel à transconductance 50 vers le nœud 48 du circuit jumeau 46. Le drain du deuxième transistor 88 est, ainsi, connecté au nœud 48 du circuit jumeau 46.

Les deux transistors 87, 88 sont donc configurés pour fournir le même courant, en sortie du suiveur, d'une part, vers le nœud 89 ou tout autre nœud de la branche 54 pour le premier transistor 87 et, d'autre part, vers le circuit jumeau 46 pour le deuxième transistor 88. Ainsi, le suiveur en tension 50 dispose de deux sorties en courant.

Les transistors 60 et 72 sont à l'origine d'une dissipation du courant les traversant. Les éléments absorbeurs de courant des transistors 60 et 72 sont modélisés par des condensateurs, visibles en traits pointillés sur la figure 2. Ainsi, le condensateur 90 et le condensateur 92 modélisent respectivement les éléments absorbeurs du courant dans la grille et le substrat du transistor 60. De même, le condensateur 96 et le condensateur 98 modélisent respectivement les éléments absorbeurs du courant dans la grille et le substrat du transistor 72. Les courants absorbés dans les grilles des transistors 60, 72 sont notés I_{grille} et les courants absorbés dans les substrats de ces transistors 60, 72 sont notés I_{sub}.

Les protections ESD 64, 78 des transistors sont également à l'origine d'une dissipation du courant les traversant. Les courants absorbés dans les protections ESD 64, 78 sont notés I_{esd}.

On comprend que lors de l'acheminement du courant I_{modulé} depuis l'entrée 24 jusqu'à la résistance 36, les condensateurs 90 et 92 du transistor 60 ainsi que la protection ESD 64 du circuit de traitement 40 absorbent une partie du courant I_{modulé}. Le courant total absorbé est donc la somme des courants absorbés par la grille du transistor 60 I_{grille}, le substrat du transistor 60 I_{sub} et la protection ESD 64 du transistor 60 I_{esd}.

Le circuit jumeau 46 étant identique au circuit de traitement 40 et réalisé sur le même substrat semi-conducteur 23 et les deux circuits étant reliés par le suiveur en tension 50, nécessairement le courant total absorbé dans les condensateurs 96 et 98 du transistor 72 et dans la protection ESD 78 du circuit jumeau 46 est égal au courant total absorbé dans les condensateurs 90 et 92 et la protection ESD 64 du transistor 60. En outre, ce courant total absorbé est également égal au courant en sortie du suiveur en tension 50.

On conçoit ainsi qu'un courant égal au courant absorbé par le transistor 60 est réinjecté au niveau du nœud 89 ou tout autre nœud de la branche principale 54 du circuit de traitement 40, compensant ainsi le courant nécessaire à la charge et à la décharge des condensateurs 90 et 92 du transistor 60 et le courant absorbé dans la protection ESD 64.

Ainsi, le circuit de traitement 40 annule la composante continue du courant I_{modulé} en sortie du convertisseur numérique-analogique lorsqu'une telle composante continue est présente et la résistance 36 convertit la composante variable du courant I_{modulé} en tension. Le circuit jumeau 46, le suiveur en tension 50 et les moyens de réinjection 51 sont aptes à compenser les pertes de courant induites par les composants non-linéaires du circuit de traitement 40, notamment par le transistor 60 et la protection ESD 64.

Ainsi, le circuit présenté dans ce premier mode de réalisation permet de conserver un très faible niveau de distorsion harmonique de par la présence d'étages cascodes tout en s'affranchissant des inconvénients liés à l'utilisation de tels étages cascodes. En particulier, la qualité de l'information contenue dans le courant I_{modulé} issu du convertisseur numérique-analogique 22 est conservée lorsque ce courant I_{modulé} est converti en tension par la résistance 36.

En outre, le convertisseur courant-tension de l'invention est utilisable aussi bien avec des composants discrets qu'en circuit intégré, tel qu'un ASIC. En particulier, les inconvénients liés à la présence d'un courant parasite absorbé dans le substrat du circuit intégré ou dans des protections ESD sont compensés par les moyens de réinjection proposés dans l'invention.

Ainsi, le gain en distorsion est de l'ordre de 15 à 20 dB.

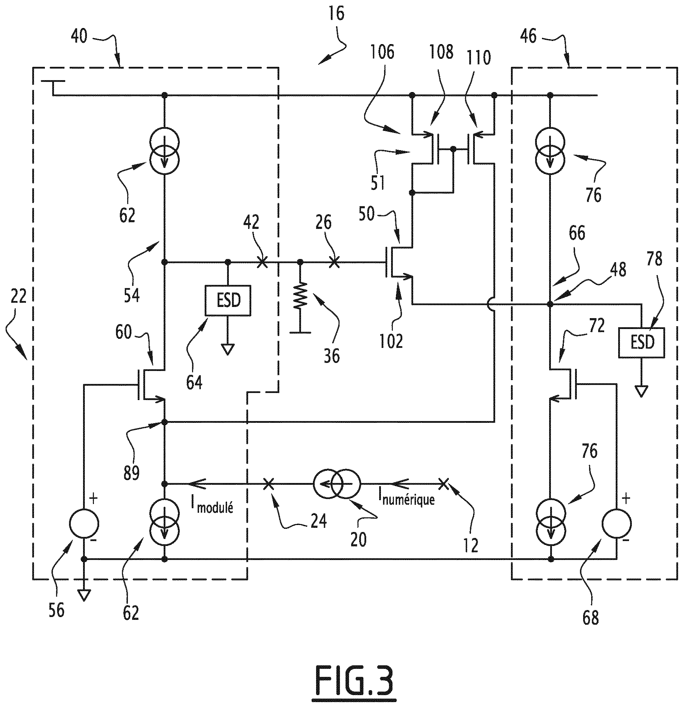

La figure 3 illustre un deuxième mode de réalisation de l'invention pour lequel les éléments identiques au premier mode de réalisation, décrit précédemment, sont repérés par les mêmes références, et ne sont pas décrits à nouveau. Seules les différences sont mises en évidence.

Sur cette figure 3 seule une partie de l'étage d'entrée 16 est représenté.

Dans ce deuxième mode de réalisation, le suiveur en tension 50 est formé d'un unique transistor 102, par exemple un transistor de type MOSFET. La grille de ce transistor 102 est connectée au circuit de traitement 40, par exemple, au niveau de son nœud 42 et sa source au circuit jumeau 46, par exemple, au niveau de son nœud 48. Le drain de ce transistor 102 est relié aux moyens de réinjection 51.

Les moyens de réinjection 51 du courant en sortie du suiveur 50 sont formés d'un circuit miroir de courant 106 apte notamment à mesurer et à réinjecter le courant en sortie du suiveur 50 dans la branche principale 54 du circuit de traitement 40.

Un tel circuit miroir de courant 106 comporte deux transistors 108 et 110 reliés l'un à l'autre par leur grille et leur source. En outre, les grilles de ces transistors 108 et 110 sont également reliées au drain du suiveur en tension 50 et les sources de ces transistors 108, 110 sont reliées à un potentiel de référence.

Le drain et la grille du transistor 108 sont reliés au suiveur en tension 50, et par là-même au circuit jumeau 46. Un tel transistor 108 assure, ainsi, l'acheminement du courant issu du suiveur en tension 50 vers le circuit jumeau 46.

Le drain du transistor 110 est relié à la branche principale 54 du circuit de traitement 40, par exemple au niveau du nœud 89. Un tel transistor 110 assure, ainsi, la réinjection dans le circuit de traitement 40 des courants absorbés par les différents composants non-linéaires du circuit de traitement 40.

Les transistors 108 et 110 formant le circuit miroir de courant sont, par exemple, des transistors MOSFET.

On conçoit que dans ce deuxième mode de réalisation, un courant de valeur égale au courant absorbé par le transistor 60 est réinjecté dans la branche principale 54 du circuit de traitement 40, compensant ainsi le courant absorbé par les composants non-linéaires du circuit de traitement 40.

Le circuit miroir de courant 106 permet, ainsi, d'obtenir une réinjection du courant absorbé par le transistor 60 sans utiliser de circuit à amplificateur opérationnel.

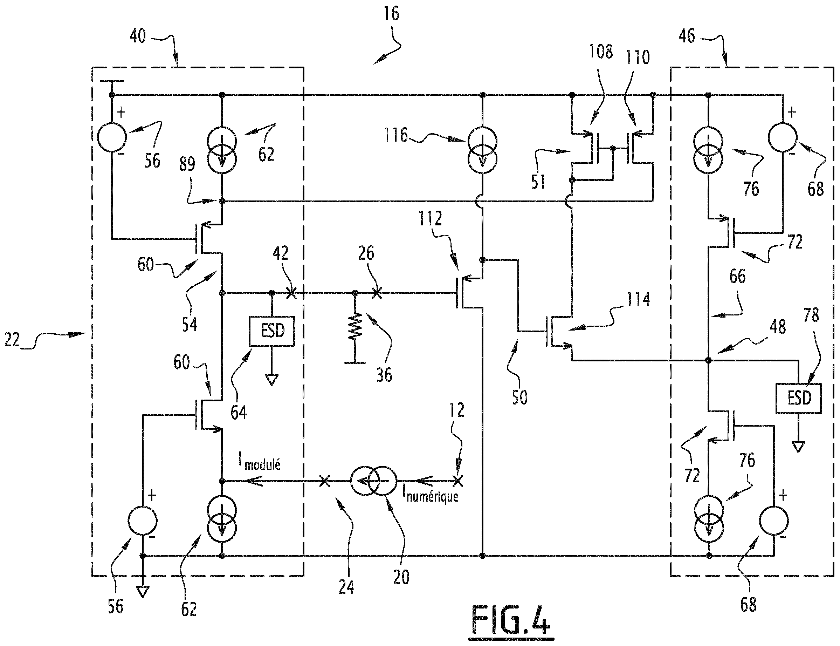

La figure 4 illustre un troisième mode de réalisation de l'invention pour lequel les éléments identiques au deuxième mode de réalisation, décrit précédemment, sont repérés par les mêmes références, et ne sont pas décrits à nouveau. Seules les différences sont mises en évidence.

Dans ce troisième mode de réalisation, le circuit de traitement 40 comporte deux transistors 60 et deux sources de tension 56.

Chaque transistor 60 est relié par sa grille à l'une des sources de tension 56 et par sa source à l'une des sources de courant 62. En outre, les deux transistors 60 sont reliés l'un à l'autre et à la sortie 26 au niveau de leur drain. Ces deux transistors 60 forment chacun un étage cascode ou à grille commune.

Le circuit jumeau 46 comprend, similairement au circuit de traitement 40, deux transistors 72 et deux sources de tension 68. Les transistors 72 sont disposés sur le même substrat semi-conducteur 23 (non représenté sur la figure 4) que les transistors 60 du circuit de traitement 40.

Chaque transistor 72 est relié par sa grille à l'une des sources de tension 68 et par sa source à l'une des sources de courant 76. En outre, les deux transistors 72 sont reliés l'un à l'autre au niveau de leur drain. Ces deux transistors 72 forment chacun un étage cascode ou à grille commune.

Dans ce troisième mode de réalisation, le suiveur en tension 50 comporte deux transistors 112 et 114, ainsi qu'une source de courant 116.

La grille du premier transistor 112 est reliée au circuit de traitement 40, par exemple au niveau du nœud 42 et sa source est reliée à la source de courant 116, ainsi qu'à la grille du deuxième transistor 114. Le drain du premier transistor 112 est relié à un potentiel de référence.

Le deuxième transistor 114 du suiveur en tension 50 est relié au niveau de sa source au circuit jumeau 46, par exemple au niveau du nœud 48, et au niveau de son drain au circuit miroir de courant 106.

Ce deuxième transistor 114 est de polarité inverse par rapport au premier transistor 112.

Les transistors 112 et 114 du suiveur en tension sont, par exemple, des transistors MOSFET.

La source de courant 116 du suiveur en tension 50 est reliée à l'une de ses extrémités à un potentiel de référence, l'autre extrémité étant reliée au premier transistor 112 du suiveur en tension 50.

Ainsi, dans ce troisième mode de réalisation, les étages cascodes sont dupliqués de sorte à garantir l'absence de distorsion harmonique. L'étage cascode du « bas » de la figure 4, formé par le transistor 60 relié au convertisseur numérique-analogique 20, permet d'isoler les sources de courant 62 et 20 de toutes variations de potentiel sur le nœud 24 même en cas de variation du potentiel sur le nœud 42, et donc d'assurer un fonctionnement optimal de ces sources de courant 62, 20. Il en est de même pour l'étage cascode du « haut », formé par le transistor 60 non directement relié au convertisseur numérique-analogique 20, qui permet d'isoler la source de courant 62 d'une variation de potentiel sur le nœud 89 même s'il y a une variation du potentiel sur le nœud 42.

En outre, la combinaison de deux transistors 112, 114 pour former le suiveur en tension 50 permet d'augmenter la qualité du suiveur 50 par rapport à un montage à un seul transistor.

En effet, le suiveur 50 du deuxième mode de réalisation comprenant un seul transistor, n'est pas idéal dans la mesure où il fait chuter la tension au niveau de sa source par rapport à la tension au niveau de sa grille. L'ajout d'un deuxième transistor 114 de polarité inverse au suiveur en tension 50 permet alors de faire monter la tension au niveau de la source de ce deuxième transistor par rapport à la tension au niveau de sa grille d'une valeur identique à la valeur de chute de tension du premier transistor. On comprend, ainsi, que les tensions des deux transistors se compensent de sorte que la tension en sortie du suiveur en tension 50 soit identique à sa tension d'entrée.

Ainsi, l'étage d'entrée 16 selon l'invention permet, notamment dans les trois modes de réalisation décrit précédemment, de maîtriser les pertes de courant dans le substrat d'un convertisseur courant-tension.

Suivant un quatrième mode de réalisation de l'invention, non représenté sur les figures, le suiveur en tension 50 comporte une seule sortie reliée au circuit jumeau 46. Le suiveur en tension 50 est un amplificateur à gain en tension unitaire.

L'alimentation du suiveur en tension 50 est reliée à un circuit miroir de courant. Un tel circuit miroir de courant est propre à mesurer le courant d'alimentation du suiveur 50 et à le réinjecter dans le circuit de traitement 40.

Ainsi, dans ce quatrième mode de réalisation, la fonction de suiveur en tension est assurée par un amplificateur à gain en tension unitaire. La fonction de mesure et de réinjection du courant en sortie du suiveur 50 dans le circuit de traitement 40 est assurée par le circuit miroir de courant placé sur le circuit d'alimentation du suiveur 50. En effet, le courant consommé par le suiveur 50 est égal au courant fourni en sortie du suiveur 50.

## Revendications

1. Convertisseur (22) courant-tension apte à recevoir un courant d'entrée (I_{modulée}) comportant une composante variable, le convertisseur comprenant :
- une entrée (24) pour le courant à convertir ;
- une sortie (26) pour la tension convertie ;
- une résistance (36) de conversion du courant en tension reliée entre la sortie (26) et un potentiel de référence,
- un circuit de traitement (40) configuré pour acheminer le courant d'entrée (Imodulée) depuis l'entrée (24) vers la résistance (36) comportant :
+ une source de tension (56),
+ une branche principale (54) comportant au moins un transistor (60) dont la grille est reliée à la source de tension (56) et au moins une source de courant (62) connectée en série avec le transistor (60), l'entrée (24) étant reliée à la sortie (26) au travers du transistor (60),
**caractérisé en ce qu'**il comporte en outre :
- un circuit jumeau (46) comportant :
+ une source de tension (68) identique à la source de tension (56) du circuit de traitement (40),
+ une branche jumelle (66) identique à la branche principale (54) du circuit de traitement (40),
- un suiveur en tension (50) connecté en entrée à la branche principale (54) du circuit de traitement (40) et en sortie à la branche jumelle (66) du circuit jumeau (46), et
- des moyens de réinjection (51, 106) du courant en sortie du suiveur (50) dans la branche principale (54) du circuit de traitement (40),
et **en ce que** le suiveur en tension (50) comporte une première sortie pour acheminer un courant à un nœud (48) du circuit jumeau (46) et une deuxième sortie pour réinjecter un courant, égal au courant issu de la première sortie, à un nœud (89) de la branche principale (54), comportant la au moins une source de courant (62), du circuit de traitement (40), le convertisseur (22) étant réalisé sur un substrat (23).

2. Convertisseur (22) selon la revendication 1, **caractérisé en ce que** les moyens de réinjection (51, 106) comportent des moyens de mesure du courant en sortie du suiveur en tension (50), lesdits moyens de mesure du courant comprenant un circuit miroir de courant (106).

3. Convertisseur (22) selon la revendication 2, **caractérisé en ce que** le circuit miroir de courant (106) comporte un premier transistor (108) assurant l'acheminement d'un courant vers le circuit jumeau (46) et un deuxième transistor (110) assurant la réinjection d'un courant dans la branche principale (54) du circuit de traitement (40).

4. Convertisseur (22) selon l'une quelconque des revendications précédentes, **caractérisé en ce que** la sortie des moyens de réinjection (51, 106) du courant en sortie du suiveur (50) est reliée à un nœud (89) de la branche principale (54) du circuit de traitement (40) dont le potentiel est fixe.

5. Convertisseur (22) selon l'une quelconque des revendications précédentes, **caractérisé en ce que** le transistor (60) du circuit de traitement (40) comporte une protection ESD (64), le circuit jumeau (46) comportant une protection ESD (78) identique à la protection ESD (64) du transistor (60).

6. Convertisseur (22) selon l'une quelconque des revendications précédentes, **caractérisé en ce que** le suiveur en tension (50) comporte un amplificateur opérationnel à transconductance (80).

7. Convertisseur (22) selon l'une quelconque des revendications précédentes, **caractérisé en ce que** le suiveur en tension (50) comporte un unique transistor (102).

8. Convertisseur (22) selon l'une quelconque des revendications 1 à 6, **caractérisé en ce que** le suiveur en tension (50) est formé d'un premier transistor (112) et d'un deuxième transistor (114) de polarité inverse à celle du premier transistor (112), le deuxième transistor (114) étant apte à compenser les chutes de tension entre la source et la grille du premier transistor (112).

9. Convertisseur (22) selon l'une quelconque des revendications précédentes, **caractérisé en ce que** chaque transistor (60, 72) forme un étage cascode, imposant une tension fixe aux bornes des sources de courant (62, 76) auxquels ils sont reliés.

10. Convertisseur (22) selon l'une quelconque des revendications précédentes, **caractérisé en ce qu'**il est réalisé sur un circuit intégré.

11. Convertisseur (22) selon l'une quelconque des revendications précédentes, **caractérisé en ce que** les transistors (60, 72) du circuit de traitement (40) et du circuit jumeau (46) sont réalisés sur un même substrat semi-conducteur (23).

12. Etage d'entrée (16) d'un amplificateur (10) comportant un convertisseur numérique-analogique (20) à sortie en courant et un convertisseur courant-tension (22) selon l'une quelconque des revendications 1 à 11.

13. Amplificateur (10), **caractérisé en ce qu'**il comporte un étage d'entrée (16) selon la revendication 12, et un étage d'amplification (18), connecté en série à l'étage d'entrée (16).

## Patentansprüche

1. Strom-Spannungswandler (22), der geeignet ist, einen Eingangsstrom (I_{modulée}) zu empfangen, der eine variable Komponente aufweist, wobei der Wandler umfasst:
- einen Eingang (24) für den umzuwandelnden Strom;
- einen Ausgang (26) für die gewandelte Spannung;
- einen Widerstand (36) der Umwandlung des Stroms in Spannung, der zwischen den Ausgang (26) und ein Referenzpotenzial geschaltet ist,
- einen Verarbeitungsschaltkreis (40), der ausgebildet ist, den Eingangsstrom (I_{modulée}) vom Eingang (24) zum Widerstand (36) zu leiten, aufweisend:
+ eine Spannungsquelle (56),
+ einen Hauptzweig (54), der mindestens einen Transistor (60), dessen Gate mit der Spannungsquelle (56) verbunden ist, und mindestens eine Stromquelle (62) aufweist, die in Reihe mit dem Transistor (60) geschaltet ist, wobei der Eingang (24) über den Transistor (60) an den Ausgang (26) geschaltet ist,
**dadurch gekennzeichnet, dass** er außerdem aufweist:
- einen Zwillingsschaltkreis (46), der aufweist:
+ eine Spannungsquelle (68), identisch zu der Spannungsquelle (56) des Verarbeitungsschaltkreises (40),
+ einen Zwillingszweig (66), identisch zu dem Hauptzweig (54) des Verarbeitungsschaltkreises,
- einen Spannungsfolger (50), der am Eingang mit dem Hauptzweig (54) des Verarbeitungsschaltkreises (40) und am Ausgang mit dem Zwillingszweig (66) des Zwillingsschaltkreises (46) verbunden ist, und
- Mittel zur Rückkopplung (51, 106) des Stroms am Ausgang des Folgers (50) in den Hauptzweig (54) des Verarbeitungsschaltkreises (40)
und dass der Spannungsfolger (50) einen ersten Ausgang zum Leiten eines Stroms an einen Knoten (48) des Zwillingsschaltkreises (46) und einen zweiten Ausgang zum Rückkoppeln eines vom ersten Ausgang abgegebenen Stroms an einen Knoten (89) des Hauptzweiges (54) aufweist, der die mindestens eine Stromquelle (62) des Verarbeitungsschaltkreises (40) aufweist, wobei der Wandler (22) auf einem Substrat (23) hergestellt ist.

2. Wandler (22) nach Anspruch 1, **dadurch gekennzeichnet, dass** die Rückkopplungsmittel (51, 106) Mittel zum Messen des Stroms am Ausgang des Spannungsfolgers (50) aufweisen, wobei die Mittel zum Messen des Stroms eine Stromspiegelschaltung (106) umfassen.

3. Wandler (22) nach Anspruch 2, **dadurch gekennzeichnet, dass** die Stromspiegelschaltung (106) einen ersten Transistor (108), der das Weiterleiten eines Stroms zu dem Zwillingsschaltkreis (46) sicherstellt, und einen zweiten Transistor (110) aufweist, der die Rückkopplung eines Stroms in den Hauptzweig (54) des Verarbeitungsschaltkreises (40) sicherstellt.

4. Wandler (22) nach einem beliebigen der vorhergehenden Ansprüche, **dadurch gekennzeichnet, dass** der Ausgang der Mittel (51, 106) zum Rückkoppeln des Stroms am Ausgang des Folgers (50) mit einem Knoten (89) des Hauptzweiges (54) des Verarbeitungsschaltkreises (40), dessen Potenzial fest ist, verbunden ist.

5. Wandler (22) nach einem beliebigen der vorhergehenden Ansprüche, **dadurch gekennzeichnet, dass** der Transistor (60) des Verarbeitungsschaltkreises (40) einen ESD Schutz (64) aufweist, wobei der Zwillingsschaltkreis (46) einen ESD Schutz (78) identisch zum ESD Schutz (64) des Transistor (60) aufweist.

6. Wandler (22) nach einem beliebigen der vorhergehenden Ansprüche, **dadurch gekennzeichnet, dass** der Spannungsfolger (50) einen Transkonduktanzverstärker (80) aufweist.

7. Wandler (22) nach einem beliebigen der vorhergehenden Ansprüche, **dadurch gekennzeichnet, dass** der Spannungsfolger (50) einen einzigen Transistor (102) aufweist.

8. Wandler (22) nach einem beliebigen der Ansprüche 1 bis 6, **dadurch gekennzeichnet, dass** der Spannungsfolger (50) von einem ersten Transistor (112) und einem zweiten Transistor (114) mit entgegengesetzter Polarität zu dem ersten Transistor (112) gebildet wird, wobei der zweite Transistor (114) geeignet ist, die Spannungsabfälle zwischen dem Source Anschluss und dem Gate des ersten Transistor (112) zu kompensieren.

9. Wandler (22) nach einem beliebigen der vorhergehenden Ansprüche, **dadurch gekennzeichnet, dass** jeder Transistor (60, 72) eine Kaskodenstufe bildet, die eine feste Spannung auf die Klemmen der Stromquellen (62, 76), mit denen sie verbunden sind, aufzwingen.

10. Wandler (22) nach einem beliebigen der vorhergehenden Ansprüche, **dadurch gekennzeichnet, dass** er als ein integrierter Schaltkreis hergestellt ist.

11. Wandler (22) nach einem beliebigen der vorhergehenden Ansprüche, **dadurch gekennzeichnet, dass** die Transistoren (60, 72) des Verarbeitungsschaltkreises (40) und des Zwillingsschaltkreises (46) auf einem selben Halbleitersubstrat (26) hergestellt sind.

12. Eingangsstufe (16) eines Verstärkers (10), die einen Analog-Digital Wandler (20) mit Stromausgang und einen Strom-Spannungswandler (22) nach einem beliebigen der Ansprüche 1 bis 11 aufweist.

13. Verstärker (10), **dadurch gekennzeichnet, dass** er eine Eingangsstufe (16) nach Anspruch 12 und eine Verstärkerstufe (18), die in Reihe zu Eingangsstufe (16) geschaltet ist, aufweist.

## Claims

1. A current-to-voltage converter (22) able to receive an input current (I_{modulated}) having a variable component, the converter comprising:
- an input (24) for the current to be converted;
- an output (26) for the converted voltage;
- a current-to-voltage conversion resistance (36) connected between the output (26) and a reference potential,
- a processing circuit (40) configured to convey the input current (I_{modulated}) from the input (24) to the resistance (36) comprising:
+ a voltage source (56);
+ a main branch (54) comprising at least one transistor (60) whose gate is connected to the voltage source (56) and at least one current source (62) connected in series with the transistor (60), the input (24) being connected to the output (26) via the transistor (60);
**characterized in that** it comprises, in addition:
- a twin circuit (46) comprising:
+ a voltage source (68) that is identical to the voltage source (56) of the processing circuit (40);
+ a twin branch (66) that is identical to the main branch (54) of the processing circuit (40);
- a voltage follower (50) that is connected at the input to the main branch (54) of the processing circuit (40) and connected at the output to the twin branch (66) of the twin circuit (46), and
- current reinjection means (51, 106) for reinjecting the current at the output of the follower (50) into the main branch (54) of the processing circuit (40);
and **in that** the voltage follower (50) comprises a first output for conveying a current to a node (48) of the twin circuit (46) and a second output for reinjecting a current, equal to the current originating from the first output, to a node (89) of the main branch (54), comprising the at least one current source (62), of the processing circuit (40), the converter (22) being fabricated on a substrate (23).

2. A converter (22) according to claim 1, **characterized in that** the reinjection means (51, 106) comprise measurement means for measuring the current at the output of the voltage follower (50), the said current measuring means comprising a current mirror circuit (106).

3. A converter (22) according to claim 2, **characterized in that** the current mirror circuit (106) comprises a first transistor (108) serving to ensure the conveying of a current to the twin circuit (46) and a second transistor (110) serving to ensure the reinjection of a current into the main branch (54) of the processing circuit (40).

4. A converter (22) according to any one of the preceding claims, **characterized in that** the output of the current reinjection means (51, 106) for reinjecting the current at the output of the follower (50) is connected to a node (89) of the main branch (54) of the processing circuit (40) whose potential is fixed.

5. A converter (22) according to any one of the preceding claims, **characterized in that** the transistor (60) of the processing circuit (40) comprises an ESD protection element (64), the twin circuit (46) comprising an ESD protection element (78) that is identical to the ESD protection element (64) of the transistor (60).

6. A converter (22) according to any one of the preceding claims, **characterized in that** the voltage follower (50) comprises an operational transconductance amplifier (80).

7. A converter (22) according to any one of the preceding claims, **characterized in that** the voltage follower (50) comprises a single transistor (102).

8. A converter (22) according to any one of claims 1 to 6, **characterized in that** the voltage follower (50) is formed by a first transistor (112) and a second transistor (114) having a polarity opposite to that of the first transistor (112), the second transistor (114) being capable of compensating for voltage drops between the source and the gate of the first transistor (112).

9. A converter (22) according to any one of the preceding claims, **characterized in that** each transistor (60, 72) forms a cascode stage, imposing a fixed voltage across the terminals of the current sources (62, 76) to which they are connected.

10. A converter (22) according to any one of the preceding claims, **characterized in that** it is fabricated on an integrated circuit.

11. A converter (22) according to any one of the preceding claims, **characterized in that** the transistors (60, 72) of the processing circuit (40) and of the twin circuit (46) are fabricated on the same semiconductor substrate (23).

12. An input stage (16) of an amplifier (10) comprising a digital-to-analogue converter (20) at the current output and a current-to-voltage converter (22) according to any one of claims 1 to 11.

13. An amplifier (10), **characterized in that** it comprises an input stage (16) according to claim 12, and an amplification stage (18) connected in series to the input stage (16).
